# EUROPEAN PATENT SPECIFICATION

(11) **EP 0 305 167 B1**
(45) Date of publication and mention of the grant of the patent: **27.04.1994**
(21) Application number: 88307845.3
(22) Date of filing: 24.08.1988
(51) Int. Cl.: H01L 29/40, H01L 39/02, H01L 39/22

(54) **Electronic devices utilizing superconducting materials**
Elektronische Anordnungen unter Verwendung von supraleitenden Materialien
Dispositifs électroniques utilisant des matériaux supraconducteurs

(30) Priority: 24.08.1987 JP 210862/87; 24.08.1987 JP 210863/87
(43) Date of publication of application: 01.03.1989
(73) Proprietor: SEMICONDUCTOR ENERGY LABORATORY CO., LTD., Atsugi-shi Kanagawa-ken, 243 (JP)
(72) Inventor: Yamazaki, Shunpei, Tokyo (JP)
(74) Representative: Milhench, Howard Leslie

(56) References cited:
- EP-A- 0 181 191
- EP-A- 0 285 445
- DE-A- 3 810 494
- HIGH-TECH MATERIALS ALERT, vol. 5, no. 4, April 1988, pages 1-2, Technical Insights, Inc., Englewood, NJ, US; "Superconductor update"
- APPLIED PHYSICS LETTERS, vol. 52, no. 24, 13th June 1988, pages 2068-2070, American Institute of Physics; A. MOGRO-CAMPERO et al.: "Characterization of thin films of Y-Ba-Cu-O on oxidized silicon with a zirconia buffer layer"
- PATENT ABSTRACTS OF JAPAN, vol. 6, no. 194 (E-134)[1072], 2nd October 1982 ; & JP-A-57 106 186
- PATENT ABSTRACTS OF JAPAN, vol. 9, no. 321 (E-367)(2044), December 17, 1985 ; & JP-A-60 154613

## Description

### BACKGROUND OF THE INVENTION

This invention relates to an electronic device utilizing a superconducting material.

Attempts to construct solid state electronic devices utilizing superconducting materials such as Nb-Ge series metallic compounds have been made. A representative example as disclosed in EP-A-0181191 is the Josephson device which can operate on the basis of tunnel effects in the superconducting state. This superconducting device is a two-terminal switching device.

However, since the Josephson device is a two-terminal device, input signals and output signals can not be treated independently and, therefore, no amplifying function is available. Because of this, while the superconducting device can operate at very high frequencies, the design of the device is very complicated. Furthermore, there is another shortcoming in that it is inconvenient and difficult to apply to this device the conventional design procedures which are highly developed in the semiconductor industries.

Furthermore, in the case of the application of ceramic superconductors to semiconductor integrated circuits, silicon semiconductor surfaces in contact with ceramic superconductors tend to become oxidised after long use. This oxidation makes the interface between the semiconductor and the superconductor nonconductive, so that current can not pass therethrough. Similarly, as discussed in JP-A-60154613, a metal superconductor layer such as Niobium readily reacts with a silicon substrate and therefore these materials must be separated if current is to pass between them.

In order to overcome or at least substantially reduce the abovementioned problems, the present invention proposes that a surface portion of the semiconductor region of a superconducting device is coupled to a superconducting film with an insulating or semi-insulating film therebetween. The insulating film functions to allow tunnel current to flow thereacross between the superconducting film and the semiconductor region, and to protect the underlying semiconductor region from being degraded due to the influence of the overlying superconducting film or due to the fabrication process thereof. For this purpose, the thickness and energy gap of the insulating or semi-insulating film are selected so as to allow tunnel current to flow.

Therefore, according to the present invention there is provided a superconductive device comprising: a substrate; a semiconductor region formed in or on said substrate; a superconductive layer formed on said substrate; and a semi-insulating layer formed at the interface between a portion of the semiconductor region and the superconductive layer, the semi-insulating layer being arranged to permit tunnel currents to flow therethrough.

The above and further features of the present invention are set forth with particularity in the appended claims and should become clearer from consideration of the following detailed description of the exemplary embodiments of the invention given with reference to the accompanying drawings.

### BRIEF DESCRIPTION OF THE DRAWINGS

Figs.1(A) to 1(C) are cross-sectional views showing exemplary embodiments of superconducting devices in accordance with the present invention;
Figs.2(A) to 2(C) are explanatory diagrams showing the operation of a superconducting device in accordance with the present invention; and
Fig.3(A) is a circuit diagram showing an application of a superconducting device in accordance with the present invention.

### DETAILED DESCRIPTION OF THE EMBODIMENTS

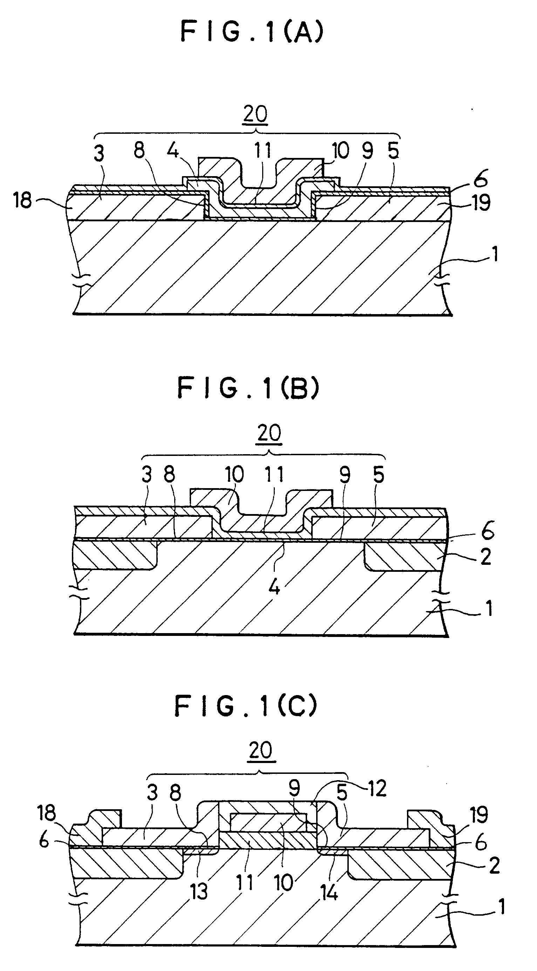

Referring to Figs.1(A) to 1(C), insulated gate field effect transistors in accordance with the present invention are illustrated.

The device as illustrated in Fig.1(A) is a first embodiment of the present invention. Superconducting ceramic films 3 and 5 are deposited on an insulating substrate 1 of YSZ (yttria stabilised zircon) or strontium titanate for example by screen press printing, sputtering, MBE (molecular beam epitaxial growth), CVD or the like. The ceramic material might for example conform to the stoichiometric formulae YBa₂Cu₃O₆₋₈, YBaSrCu₃O₆₋₈ or YBaCaCu₃O₆₋₈. Other examples of superconductive ceramic materials will be seen in the last portion of this description. When one or more of Ge, Sn, Pb, Sb, F or the like is added to these compositions, the height of barriers occurring at interfaces among crystals can be lowered. Simultaneously with the deposition of the ceramic films or thereafter, the structure is subjected to thermal annealing at 500°C - 1200°C for 5 hours - 10 hours, followed by gradual cooling.

After the formation of a semi-insulating film 6 over the ceramic films 3 and 5 and over the surface of the insulating substrate 1 between the films 3 and 5, a non-single-crystalline semiconductor film 4 such as an amorphous or microcrystalline silicon semiconductor film is formed on the structure by photo-CVD or plasma-CVD so as to straddle the intervening surface of the insulating substrate 1. The upper surface of the structure is then insulated by a nonconductive film 11. A control electrode 10 is then formed of a superconducting ceramic the same as that described above, or of a metallic material such as copper or a copper and nickel composition by vapour evaporation. Although not illustrated, the superconducting films 3 and 5 make zero-resistance contact with superconducting leads at their ends 18 and 19. Portions 8 and 9 of the semi-insulating film 6 formed between the semiconductor and the superconductors define regions for the development of tunnel currents as described hereinbelow.

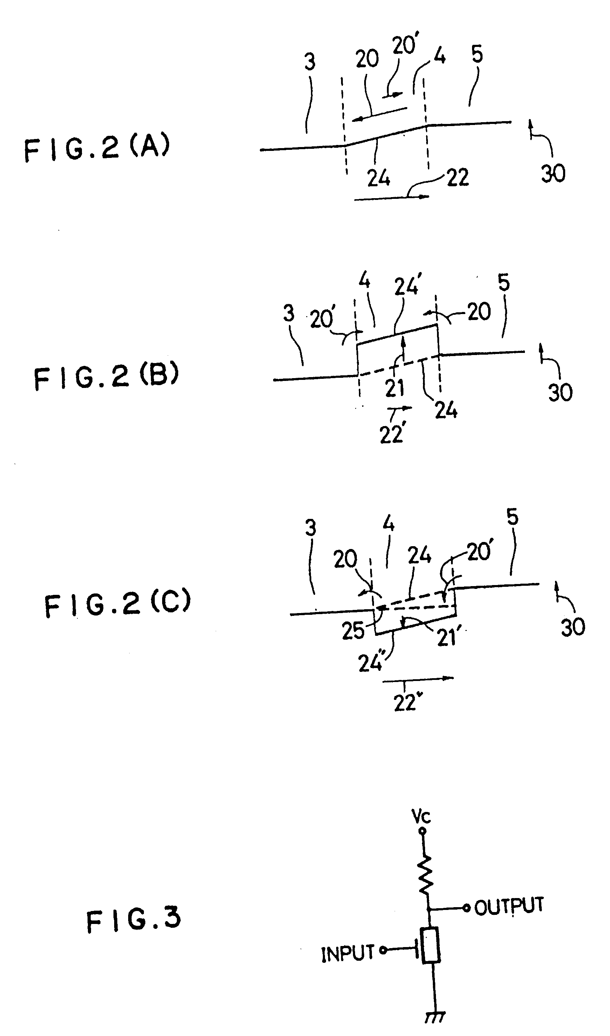

The operation of the device of Fig.1(A) will now be explained with reference to Figs.2(A) to 2(C). The lateral direction of these diagrams corresponds to the lateral direction of Fig.1(A) while the vertical direction is related to the energy level (potential).

Throughout Figs.2(A) to 2(C), the device is subjected to a voltage applied at the superconducting films 3 and 5 and across the semiconductor film 4. In Fig.2(A) there is depicted the energy state of the device in the case where no voltage is applied to the control electrode 10. The potential level of the film 5 becomes higher than that of the film 3 by an amount 30. By virtue of the differential potential 30, the electron flow 20 exceeds the electron flow 20' and, as a result, a current 22 is observed. In Fig.2(B) there is depicted the energy state in the case where a negative voltage is applied to the control electrode 10. By virtue of the potential barrier established at the active semiconductor film 4, the electron flow 20' and the electron flow 20 are supressed. Eventually, a limited current 22' is observed. In Fig.2(C) there is depicted the energy state in the case where a positive voltage is applied to the control electrode 10. By virtue of the potential well established at the film 4, the electron flow 20' is enhanced while the electron flow 20 is suppressed. However, once the potential well is filled with electrons, the potential line 24'' is shifted to the position of the broken line 25. As a result, a current 22'' comparable to the current 22 in Fig.2(A) can flow through the device.

As will be appreciated from the above explanation, the output current passing through the semiconductor film 4 can be controlled in accordance with the input voltage applied to the control electrode 10. If the non-conductive film 11 underlying the control electrode 10 provides sufficient isolation, the output energy can be larger than the input energy, and therefore amplification can be performed. Also, when arranged in a circuit as illustrated in Fig.3, the superconducting device can function as an inverter.

Fig.1(B) is a cross-sectional view showing a second embodiment of the present invention. Field insulating regions 2 are formed within a silicon semiconductor substrate 1, an active region 4 being situated between the regions 2. Superconducting films 3 and 5 are formed on the substrate surface on both sides of the active region 4 through a semi-insulating film 6 having portions 8 and 9 provided for tunnel currents. A non-conductive film 11 of silicon oxide is formed on the structure. A control electrode 10 is formed above the active region 4 and overlying end portions of the superconducting films 3 and 5.

The semi-insulating film 6 for tunnel currents is formed by heating the silicon substrate in a highly pure ammonia atmosphere at 700-950°C for 15-40 minutes in order to produce a silicon nitride film of 1-2.5 nanometers (10-25 Å) thickness on the surface of the substrate 1. Other examples of materials forming semi-insulating films are silicon oxide, silicon carbide and materials mainly comprising carbon such as diamond-like carbon. A process for the formation of carbon film materials is described in European Patent Application No. 883013641. The energy gaps of silicon oxide, silicon nitride and diamond-like carbon are 8eV, 5eV, 3eV and 1-5eV respectively.

Fig.1(C) shows a third embodiment of the present invention. Field insulating regions 2 are formed within a silicon semiconductor substrate 1 in the same manner as in the preceding embodiment. Between the insulating regions 2, a non-conductive film 11 is formed by thermal oxidation. A control film 10 is then formed of a superconducting ceramic, a silicon semiconductor or a metal oxide, and the control film 10 and the underlying non-conductive film 11 are then shaped as desired by photolithography.

Next, with the control film 10 and/or the photoresist remaining thereon used as a mask, a p-type or n-type impurity is introduced into the semiconductor substrate 1 by ion implantation in order to produce impurity regions 13 and 14 within the substrate. The impurity regions 13 and 14 function as source and drain regions for an IGFET. Semi-insulating silicon carbide films 6 of 1-3 nanometers (10-30 Å) thickness and having portions 8 and 9 are formed by heating the substrate in an atmosphere of highly pure methane at 800-1050°C. In this procedure, the doped semiconductor regions are annealed simultaneously to have an impurity density of 1 x 10¹⁹ to 1 x 10²¹ cm⁻³. A superconducting oxide is then deposited on the structure by sputtering or electron beam evaporation, and is patterned in the same manner as in foregoing embodiments to form superconducting films 3 and 5. The superconducting films 3 and 5 cover most of the surfaces portions of the impurity regions 13 and 14. Further, superconducting or non-superconducting leads 18, 19 may be formed in contact with the superconducting films 3 and 5 for connection with external circuits, if desired. Reference numeral 12 designates an overlying insulating film.

As a modification, a multi-layered superconducting structure can be designed by covering the upper surface of the superconducting film 3 or 5 with a further insulating film, forming an opening in the further insulating film, and depositing another superconducting film on the further insulating film in order to make contact with the lower superconducting film 3 or 5 through the opening.

The active regions of the semiconductor devices in accordance with the present invention can be dimensioned to be of the order of micron or less, so that the devices can be operated at frequencies in the giga-Hertz range.

Superconducting ceramics useful in the practice of the present invention also may be prepared to be consistent with the stoichiometric formulae (A₁₋ₓBₓ)_{y}Cu_{z}O_{w}Xᵥ, where A is one or more elements of Group IIIa of the Japanese Periodic Table, e.g., the rare earth elements, B is one or more elements of Group IIa of the Japanese Periodic Table, e.g., the alkaline earth metals including beryllium and magnesium, X is one or more elements of the group consisting of Ge, Sn, Pb, F and Cl, and 0 < x < 1; y = 2.0 - 4.0, preferably 2.5 - 3.5; z = 1.0 - 4.0, preferably 1.5 - 3.5; w = 4.0 - 10.0, preferably 6.0 - 8.0; and v = 0 - 3. Also, superconducting ceramics for use in the practice of the present invention may be prepared to be consistent with the stoichiometric formulae (A₁₋ₓBₓ)_{y}Cu_{z}O_{w}, where A is one or more elements of Group Vb of the Japanese Periodic Table such as Bi, Sb and As, B is one or more elements of Group IIa of the Japanese Periodic Table, e.g., the alkaline earth metals including beryllium and magnesium, and x = 0.3 - 1; y - 2.0 - 4.0, preferably 2.5 - 3.5; z = 1.0 - 4.0, preferably 1.5 - 3.5; and w = 4.0 - 10.0, preferably 6.0 - 8.0. Examples of this general formula are BiSrCaCuCu₂Oₓ and Bi₄Sr₃Ca₃Cu₄Oₓ. Tc onset and Tco for samples confirmed to be consistent with the formula Bi₄Sr_{y}Ca₃Cu₄Oₓ ( y around 1.5) were measured to be 40-60°K, which is not so high. Relatively high critical temperatures were obtained with samples conforming to the stoichiometric formulae Bi₄Sr₄Ca₂Cu₂Oₓ and Bi₂Sr₃Ca₂Cu₂Oₓ. The number x denoting the oxygen proportion is 6-10, e.g. around 8.1. Such superconducting materials can for example be formed by screen press printing, vacuum evaporation or CVD.

For the avoidance of doubt it is to be noted that all references herein to the Periodic Table and to specific Groups of the Periodic Table are to be understood to refer to the Japanese Periodic Table and to the Groups thereof as described in the Iwanami "Physics and Chemistry Dictionary". As compared with the Group designations of the Periodic Table as described in "The Penguin Dictionary of Science" for example, which are the Group designations commonly accepted throughout Europe, Groups Ia, IIa, VIII, Ib, IIb and 0 are the same in the Japanese and European Periodic Tables, Groups IIIa, IVa, Va, VIa and VIIa of the Japanese Periodic Table correspond respectively to Groups IIIb, IVb, Vb, VIb and VIIb of the European Periodic Table, and Groups IIIb, IVb, Vb, VIb and VIIb of the Japanese Periodic Table correspond respectively to Groups IIIa, IVa, Va, VIa and VIIa of the European Periodic Table.

Also, organic superconducting materials which have received a great deal of attention can be used for embodying the present invention.

The present invention can be applied to MIS FETs, bipolar semiconductor devices, VLSIs or USLIs.

## Claims

1. A superconductive device comprising:
a substrate (1);
a semiconductor region (4) formed in or on said substrate (1);
a superconductive layer (3, 5) formed on said substrate (1); and
an insulating or semi-insulating layer (6) formed at the interface (8, 9) between a portion of the semiconductor region (4) and the superconductive layer (3, 5), the insulating or semi-insulating layer (6) being arranged to permit tunnel currents to flow therethrough.

2. A device according to claim 1 wherein said portion of said semiconductor region (4) is p-type or n-type.

3. A device according to claim 1 or 2 wherein said semiconductor region (4) is a region of a field effect semiconductor device.

4. A device according to any of the preceding claims wherein said semi-insulating layer (6) comprises a silicon nitride film.

5. A device according to any of claims 1 to 3 wherein said semi-insulating layer (6) comprises a silicon oxide film.

6. A device according to claim 3 or of claim 4 or 5 as dependent upon claim 3 further comprising a control electrode (10) formed on an active region (4) of said field effect semiconductor device.

7. A device according to claim 6 wherein said control electrode (10) comprises a superconductive material.

8. A device according to any of the preceding claims wherein said superconductive layer (3, 5) is adapted to function as a lead line extending from said portion of said semiconductor region (4).

9. A device according to any of the preceding claim wherein said superconductive layer (3, 5) comprises a ceramic oxide superconductor.

## Patentansprüche

1. Supraleitendes Bauelement mit:
- einem Substrat (1);
- einem in oder auf dem Substrat (1) ausgebildeten Halbleiterbereich (4);
- einer auf dem Substrat (1) ausgebildeten supraleitenden Schicht (3, 5); und
- einer isolierenden oder halbisolierenden Schicht (6), die an der Grenzfläche (8, 9) zwischen einem Teil des halbleitenden Bereichs (4) und des supraleitenden Bereichs (3, 5) ausgebildet ist, wobei die isolierende oder halbisolierende Schicht (6) so ausgebildet ist, daß sie es erlaubt, daß Tunnelströme durch sie fließen.

2. Bauelement nach Anspruch 1, bei dem der Teil des Halbleiterbereichs (4) vom p- oder n-Typ ist.

3. Bauelement nach Anspruch 1 oder Anspruch 2, bei dem der Halbleiterbereich (4) ein Bereich eines Feldeffekt-Halbleiterbauelements ist.

4. Bauelement nach einem der vorstehenden Ansprüche, bei dem die halbisolierende Schicht (6) einen Siliziumnitridfilm aufweist.

5. Bauelement nach einem der Ansprüche 1 bis 3, bei dem die halbisolierende Schicht (6) einen Siliziumoxidfilm aufweist.

6. Bauelement nach Anspruch 3 oder nach einem der Ansprüche 4 oder 5 in Abhängigkeit von Anspruch 3, ferner mit einer auf einem aktiven Bereich (4) des Feldeffekt-Halbleiterbauelements ausgebildeten Steuerelektrode (10).

7. Bauelement nach Anspruch 6, bei dem die Steuerelektrode (10) ein supraleitendes Material aufweist.

8. Bauelement nach einem der vorstehenden Ansprüche, bei dem die supraleitende Schicht (3, 5) so ausgebildet ist, daß sie als Zuleitung fungiert, die sich vom besagten Teil des Halbleiterbereichs (4) aus erstreckt.

9. Bauelement nach einem der vorstehenden Ansprüche, bei dem die supraleitende Schicht (3, 5) einen keramischen Oxidsupraleiter aufweist.

## Revendications

1. Dispositif supraconducteur comportant :
un substrat (1) ;
une région semi-conductrice (4) formée dans ou au-dessus dudit substrat (1) ;
une couche supraconductrice (3, 5) formée sur ledit substrat (1) ; et
une couche isolante ou semi-isolante (6) formée au niveau de l'interface (8, 9) entre une portion de la région semi-conductrice (4) et de la couche supraconductrice (3, 5), la couche isolante ou semi-isolante (6) étant agencée pour permettre la circulation de courants de tunnel à travers celles-ci.

2. Dispositif selon la revendication 1, dans lequel ladite portion de ladite région semi-conductrice (4) est du type p ou du type n.

3. Dispositif selon les revendications 1 ou 2, dans lequel ladite région semi-conductrice (4) est une région d'un dispositif semi-conducteur à effet de champ.

4. Dispositif selon l'une quelconque des revendications précédentes, dans lequel ladite couche semi-isolante (6) comporte un film au nitrure de silicium.

5. Dispositif selon l'une quelconque des revendications 1 à 3, dans lequel ladite couche semi-isolante (6) comporte un film en oxyde de silicium.

6. Dispositif selon la revendication 3 ou les revendications 4 ou 5 lorsqu'elles dépendent de la revendication 3, comportant en outre une électrode de commande (10) formée sur une région active (4) dudit dispositif semi-conducteur à effet de champ.

7. Dispositif selon la revendication 6, dans lequel ladite électrode de commande (10) comporte un matériau supraconducteur.

8. Dispositif selon l'une quelconque des revendications précédentes, dans lequel ladite couche supraconductrice (3, 5) est adaptée pour fonctionner comme circuit de liaison s'étendant depuis ladite portion de ladite région semi-conductrice (4).

9. Dispositif selon l'une quelconque des revendications précédentes, dans lequel ladite couche supraconductrice (3, 5) comporte un supraconducteur en un oxyde de céramique.
